# EUROPÄISCHE PATENTSCHRIFT

(11) **EP 4 239 420 B1**
(45) Veröffentlichungstag und Bekanntmachung des Hinweises auf die Patenterteilung: **29.04.2026**
(21) Anmeldenummer: 22160011.7
(22) Anmeldetag: 03.03.2022
(51) Int. Cl.: G05B 13/02

(54) **VERFAHREN ZUM BETRIEB EINER INDUSTRIELLEN STEUERUNGSANLAGE UND INDUSTRIELLE STEUERUNGSANLAGE**
INDUSTRIAL CONTROL SYSTEM AND METHOD FOR OPERATING AN INDUSTRIAL CONTROL SYSTEM
PROCÉDÉ DE FONCTIONNEMENT D'UNE INSTALLATION INDUSTRIELLE DE COMMANDE ET INSTALLATION INDUSTRIELLE DE COMMANDE

(43) Veröffentlichungstag der Anmeldung: 06.09.2023
(73) Patentinhaber: Siemens Aktiengesellschaft, 80333 München (DE)
(72) Erfinder: Fischer, Peter, 92421 Schwandorf (DE); Weikert, Robert, 92342 Burggriesbach (DE)
(74) Vertreter: Siemens Patent Attorneys

(56) Entgegenhaltungen:
- CN-B- 107 070 350
- DE-A1- 102020 128 323

## Beschreibung

Die Erfindung betrifft ein Verfahren zum Betrieb einer industriellen Steuerungsanlage umfassend eine Automatisierungssteuerung mit einem Ablaufprogramm, einem Ansteuermittel ausgestaltet, zum Ansteuern einer Schaltkomponente der Leistungselektronik und eine Eingabebaugruppe, wobei durch Ein- und Ausschaltvorgänge der Schaltkomponente Elektromagnetische Störungen auftreten, welche einen über die Eingabebaugruppe aufgenommenen Messwert verfälschen.

Auch betrifft die Erfindung eine industrielle Steuerungsanlage umfassend eine Automatisierungssteuerung mit einem Ablaufprogramm, einem Ansteuermittel ausgestaltet zum Ansteuern einer Schaltkomponente der Leistungselektronik und eine Eingabebaugruppe, wobei durch Ein- und Ausschaltvorgänge der Schaltkomponente Elektromagnetische Störungen auftreten, welche einen über die Eingabebaugruppe aufgenommenen Messwert verfälschen.

Automatisierungssteuerungen, wie z.B. speicherprogrammierbare Steuerungen, werden in komplexen industriellen Anlagen häufig in Schaltschränken mit unterschiedlichen Komponenten wie Sensoren, Messumwandler, Motoren, Stromrichter und Umrichtern, eingesetzt.

Es ist bekannt, dass gerade Stromrichter und/oder Umrichter betriebene Motoren lokal ein breites Störspektrum an elektromagnetischen Störungen erzeugen. Insbesondere aufgrund der Nähe im Schaltschrank, sowie der zwangsläufig nahen Verdrahtung kann der Betrieb eines Stromrichters/Umrichters betriebenen Motors die analogen Eingänge der speicherprogrammierbaren Steuerung stören und zu einem zusätzlichen Messfehler führen.

Die CN 107070 350 B offenbart ein Verfahren um einen Stromrichter zu steuern und dabei mögliche elektromagnetische Störungen vorherzusagen.

Die DE 10 2020 128 323 Al offenbart eine Steuerungsvorrichtung, welche ein Rauschen und eine mögliche Störung eines Sensorsignals möglichst unterdrückt um das Signal nicht zu verfälschen.

Es ist demnach Aufgabe der vorliegenden Erfindung ein Verfahren bzw. eine Anlage bereitzustellen, bei welchem bzw. bei welcher Störungen durch Einschaltvorgänge bei Messwerten korrigiert oder kompensiert werden können.

Für das eingangs genannte Verfahren wird die Aufgabe dadurch gelöst, dass für die Schaltkomponente ein zeitliches Auftreten der Ein- und Ausschaltvorgänge und/oder ein Betriebszustand vorhergesagt wird, wobei die Vorhersage dazu genutzt wird, eine Korrektur des Messwertes zu einem Vorhersagezeitpunkt oder während einem Vorhersage-Zeitbereich bezüglich der Verfälschung durch die Elektromagnetische Störung durchzuführen, wobei ein zeitliches Auftreten von Programmcode-Anweisungen in dem Ablaufprogramm dazu genutzt wird die Ein- und Ausschaltvorgänge und/oder den Betriebszustand vorherzusagen.

Es ergibt sich somit eine Korrektur, beispielsweise eines analogen Messwertes beim Anfahren des Motors sowie ein Korrekturwert in Abhängigkeit von der stationären Drehzahl des Motors. Das Anfahren des Motors kann man aus dem Programmcode-Anweisungen ersehen. In der Automatisierungskomponente mit ihrem Ablaufprogramm ist der Zeitpunkt, an dem eine Freigabe für einen Umrichter gesetzt wird, bekannt. Die Auswirkungen des durch den Umrichter gestarteten Motor ist im zeitlichen Verlauf des Analogwertes eines Sensors erkennbar. Beispielsweise ein erhöhter Anlaufstrom des Motors oder ein weiteres Frequenzgemisch des Umrichters durch die hochlaufende Drehzahl des Drehfeldes kann rund um den Ausgang des Umrichters erkannt werden. Sowohl für den Hochlauf als auch für den stationären Betrieb kann die Auswirkung des Motors auf die analogen Eingänge analysiert werden.

Es gibt im Wesentlichen drei verschiedene Zustände
- Analogwert bei deaktivierten Motor,
- Analogwert während des Motorhochlaufs,
- Analogwert bei statischer Motordrehzahl,
- Analogwert beim aktiven/passiven bremsen des Motors.

Es ergibt sich damit ein Lösungsansatz zur Korrektur des Analogwertes beim Anfahren des Motors sowie ein Korrekturwert in Abhängigkeit von der stationären Drehzahl des Motors.

Das Verfahren kann weiterhin dadurch verbessert werden, wobei zusätzlich ein Aufzeichnungsmodul derart betrieben wird, dass während des Betriebes der industriellen Steuerungsanlage ein Lernprozess für ein Neuronales-Netz in dem Aufzeichnungsmodul durchgeführt wird, dabei wird ein überwachtes Lernen durchgeführt, wobei eine im vor hinein festgelegte zu lernende Ausgabe der Vorhersagezeitpunkte durch das zeitliche Auftreten der Programmcode-Anweisungen in dem Ablaufprogramm mit den tatsächlichen auftretenden elektromagnetischen Störungen mittels Sensordaten von Sensoren, welche an den Schaltkomponenten und/oder an einzuschaltenden Antrieben Elektromagnetische Störungen aufzeichnen, überwacht wird, wobei aus den Sensordaten die tatsächlichen Zeitpunkte der Störungen ermittelt werden und dem Neuronalen-Netz als zusätzliche Eingangsgrößen zur Verfügung gestellt werden. Durch diesen Lernprozess erhält man ein später unabhängig von dem Automatisierungsgerät arbeitendes Neuronales-Netz, welches später zur Störkompensation direkt auf einer Eingabebaugruppe eingesetzt werden kann.

Weiterhin ist es vorteilhaft, wenn die Eingabebaugruppe mit einem digitalen Filter betrieben wird, welcher den aufgenommenen Messwert gegen Störeinflüsse stabilisiert, dabei wird die Vorhersage dazu genutzt, den Filter zu parametrieren und mit dem parametrierten Filter werden die Störeinflüsse minimiert.

Alternativ besteht die Möglichkeit mittels einer künstlichen Intelligenz KI bedarfsgerichtet entweder die Länge des benötigten digitalen Filters zu ermitteln oder gezielt einen digitalen Filterentwurf (FIR, IIR) zu erstellen und diesen an die betroffenen Analogbaugruppen zu übertragen. Damit erfolgt die Korrektur schon in der Baugruppe. Es sind in diesem Fall kürzere Verzögerungszeiten bei gleicher oder besserer Störunterdrückung möglich.

Die Aufgabe wird ebenfalls durch eine eingangs genannte industrielle Steuerungsanlage dadurch gelöst, dass ein Vorhersagemittel vorhanden ist, welches ausgestaltet ist, für die Schaltkomponente ein zeitliches Auftreten der Ein- und Ausschaltvorgänge und/oder ein Betriebszustand vorherzusagen, weiterhin weist die industrielle Steuerungsanlage ein Korrekturmittel auf, welches ausgestaltet ist, zu einem Vorhersagezeitpunkt oder während eines Vorhersagezeitbereichs bezüglich der Verfälschung durch die Elektromagnetische Störung den Messwert zu korrigieren, dabei ist das Vorhersagemittel weiterhin dazu ausgestaltet, ein zeitliches Auftreten von Programmcode-Anweisungen in dem Ablaufprogramm dahingehend auszuwerten, die Ein- und Ausschaltvorgänge und/oder den Betriebszustand der Schaltkomponente der Leistungselektronik vorherzusagen.

Im Hinblick auf den Einsatz von künstlicher Intelligenz KI ist es von Vorteil, wenn ein Aufzeichnungsmodul mit einem Neuronalen-Netz vorhanden ist und ausgestaltet ist während des Betriebs der industriellen Steuerungsanlage einen Lernprozess für das Neuronale-Netz durchzuführen, dabei ist das Aufzeichnungsmodul weiterhin dazu ausgestaltet, ein überwachtes Lernen durchzuführen, bei welchem eine im vor hinein festgelegte zu lernende Ausgabe der Vorhersagezeitpunkte durch das zeitliche Auftreten der Programmcode-Anweisungen in dem Ablaufprogramm mit den tatsächlich auftretenden elektromagnetischen Störungen mittels Sensordaten von Sensoren, welche an den Schaltkomponenten und/oder an einzuschaltenden Antrieben angeordnet sind, überwacht wird, wobei das Aufzeichnungsmodul ausgestaltet ist, die tatsächlichen Zeitpunkte der Störungen aus den Sensordaten zu ermitteln und dem Neuronalen-Netz als zusätzliche Eingangsgrößen zur Verfügung zu stellen.

Mit einem derart angelernten Neuronalen-Netz kann eine Fehlerkorrektur auch direkt auf der Eingabebaugruppe erfolgen und muss nicht erst über einen Umweg in der speicherprogrammierbaren Steuerung durchgeführt werden.

Eine weitere Ausgestaltung sieht vor, dass die Eingabebaugruppe mit einem digitalen Filter ausgestaltet ist, welcher den aufgenommenen Messwert gegen Störeinflüsse stabilisiert, dabei ist die Eingabebaugruppe ausgestaltet, mittels der Vorhersage den Filter zu parametrieren und mit dem parametrierten Filter die Störeinflüsse zu minimieren.

Es ist nun möglich, beispielsweise die Länge einer Filterzeit genau einzustellen. Je länger eine Filterzeit gewählt wird, desto stabiler ist ein Messwert gegen Störeinflüsse, auf der anderen Seite bedingt eine höhere bzw. längere Filterzeit auch eine langsamere Datenrate der Messwerte und trägere Reaktionszeiten auf tatsächliche Messwertänderungen. Es wird daher mit der Kenntnis der Vorhersagezeit ein Optimum zwischen minimalen Störeinflüssen und einer maximalen Datenrate erreicht, wobei die Filterzeit optimal angepasst werden kann.

Die Zeichnung zeigt ein Ausführungsbeispiel der Erfindung, dabei zeigt die
- FIG 1: ein Übersichtsbild einer industriellen Steuerungsanlage,
- FIG 2: ein zeitliches Diagramm von Einschaltvorgängen und Ausschaltvorgängen mit einem Vorhersagezeitpunkt und
- FIG 3: eine Messwertkennlinie eines Messwertes mit einer Kompensation.

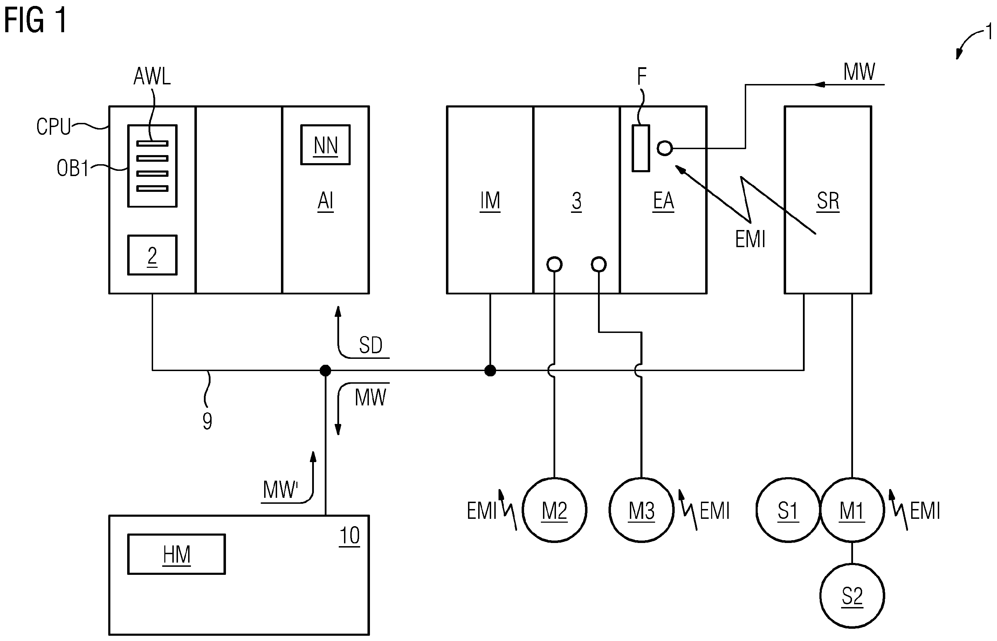

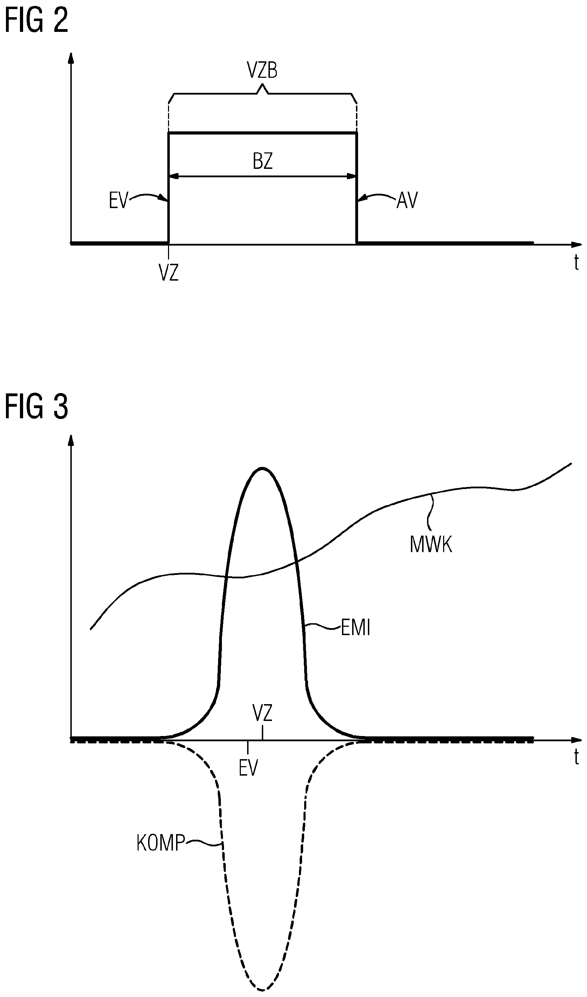

Gemäß FIG 1 ist eine industrielle Steuerungsanlage 1 umfassend eine Automatisierungssteuerung CPU mit einem Ablaufprogramm OB1 dargestellt. Das Ablaufprogramm OB1 enthält Programmcode-Anweisungen AWL, eine der Programmcode-Anweisungen AWL wird letztendlich zu einem bestimmten Zeitpunkt die Schaltkomponente SR über ein Ansteuermittel 2 zur Ansteuerung einer Leistungselektronik aktivieren. Oder eine Programmcode-Anweisung AWL wird über eine Ausgabebaugruppe 3 direkt einen Motor ansteuern. Die Automatisierungssteuerung CPU ist demnach mit dem Ansteuermittel 2 ausgestaltet zum Ansteuern der Schaltkomponente SR der Leistungselektronik und über eine Eingabebaugruppe EA kann ein Messwert MW aufgenommen werden. Durch Ein- und Ausschaltvorgänge EV,AV (siehe FIG 2) der Schaltkomponente SR entstehen Elektromagnetische Störungen EMI, welche über die Eingabebaugruppe EA aufgenommen werden und den Messwert verfälschen können.

Die industrielle Steuerungsanlage 1 umfasst daher ein Vorhersagemittel 10, welches ausgestaltet ist, für die Schaltkomponente SR ein zeitliches Auftreten der Ein- und Ausschaltvorgänge EV,AV und/oder eine Zeitdauer eines Betriebszustandes BZ vorherzusagen. Weiterhin ist ein Korrekturmittel KM vorhanden, welches ausgestaltet ist, zu einem Vorhersagezeitpunkt VZ oder während eines Vorhersagezeitbereichs VZB bezüglich der Verfälschung durch die Elektromagnetische Störung EMI, den Messwert MW zu korrigieren. Wird die Schaltkomponente SR, beispielsweise ein Umrichter, aktiviert so aktiviert dieser Umrichter wiederum einen ersten Motor M1. An dem ersten Motor M1 ist ein erster Sensor S1 und ein zweiter Sensor S2 angeordnet. Sowohl das Ansteuern der Schaltkomponente SR bzw. des Umrichters als auch wiederum die Ansteuerung des ersten Motors M1 lassen Elektromagnetische Störungen EMI entstehen. Die Automatisierungssteuerung CPU ist über einen Bus 9 mit der Schaltkomponente SR und der Eingabebaugruppe EA kommunikationstechnisch verbunden. In diesem besonderen Fall ist die Eingabebaugruppe EA an ein Interface-Modul IM über einen Rückwandbus mit einer zusätzlichen Ausgabebaugruppe 3 gekoppelt. Nimmt die Eingabebaugruppe EA einen Messwert MW auf und schaltet zu einem bestimmten Zeitpunkt die Schaltkomponente SR ein, werden wiederum Elektromagnetische Störungen EMI auf den Messwert MW übertragen, so wird dann ein verfälschter Messwert MW über den Bus 9 an das Vorhersagemittel 10 übertragen. In dem Vorhersagemittel 10 ist ein Korrekturmittel KM eingebettet, welches aufgrund des nun bekannten Vorhersagezeitpunktes VZ den Messwert MW korrigiert. Das Vorhersagemittel 10 kann einen korrigierten Messwert MW' zur Automatisierungssteuerung CPU senden.

Das Vorhersagemittel 10 ist weiterhin ausgestaltet, ein zeitliches Auftreten der Programmcode-Anweisungen AWL in dem Ablaufprogramm OB1 dahingehend auszuwerten, dass die Ein- und Ausschaltvorgänge EV,AV und/oder der Betriebszustand BZ der Schaltkomponente SR mit in die Vorhersage einbezogen werden.

Dabei wird ein Aufzeichnungsmodul AI zur Hilfe genommen. Das Aufzeichnungsmodul AI weist ein Neuronales-Netz NN auf, welches ausgestaltet ist, während des Betriebs der industriellen Steuerungsanlage 1 einen Lernprozess für das Neuronale-Netz NN durchzuführen, dabei ist das Aufzeichnungsmodul AI weiterhin dazu ausgestaltet, ein überwachtes Lernen durchzuführen, bei welchem eine im vor hinein festgelegte zu lernende Ausgabe der Vorhersagezeitpunkte durch das zeitliche Auftreten der Programmcode-Anweisungen AWL in dem Ablaufprogramm OB1 mit den tatsächlichen auftretenden elektromagnetischen Störungen mittels Sensordaten von dem ersten Sensor S1 und dem zweiten Sensor S2, welche im Umfeld der Schaltkomponenten SR bzw. direkt an einem ersten Motor angeordnet sind, überwacht wird. Das Aufzeichnungsmodul AI ist ausgestaltet, die tatsächlichen Zeitpunkte der Störungen aus den Sensordaten SD zu ermitteln und dem Neuronalen-Netz NN als zusätzliche Eingangsgrößen zur Verfügung zu stellen.

Die Eingabebaugruppe EA weist einen digitalen Filter F auf, welcher ausgestaltet ist, den aufgenommenen Messwert gegen Störeinflüsse zu stabilisieren, dabei ist die Eingabebaugruppe EA ausgestaltet, mittels der Vorhersage den Filter F entsprechend zu parametrieren. Mit dem parametrierten Filter F können ebenfalls die Störeinflüsse minimiert werden. Eine lange Filterzeit macht beispielsweise einen Messwert MW gegen Störeinflüsse stabiler. Aber bedingt durch eine höhere Filterzeit erhält man auch eine langsamere Datenrate der Messwerte MW und trägere Reaktionszeiten RZ.

Eine optimal eingestellte Filterzeit des Filters F auf der Eingabebaugruppe EA ist somit von Vorteil.

Die FIG 2 zeigt den zeitlichen Verlauf eines Einschaltvorganges EV und eines Ausschaltvorganges AV. Zu einem Vorhersagezeitpunkt VZ startet der Einschaltvorgang EV. Nun befindet sich die Schaltkomponente SR in einem Betriebszustand BZ für einen Vorhersagezeitbereich VZB. Endet die Zeit des Vorhersagezeitbereichs VZB so stimmt auch zeitlich überein, der Ausschaltvorgang AV mit dem Ende des Vorhersagezeitbereichs VZB.

Gemäß FIG 3 ist eine Messwertkennlinie MWK der Messwerte MW dargestellt. Beispielsweise startet wird zu einem Einschaltvorgang EV ein Motor M1 gestartet und eine Elektromagnetische Störung EMI auftreten. Da nun der Vorhersagezeitpunkt VZ bekannt ist, kann man rund um das Auftreten der elektromagnetischen Störung EMI zeitlich eine Kompensation KOMP auf dem Messwert MW bzw. die Messwertkennlinie MWK aufaddieren und erhält so einen korrigierten Messwert MW bzw. eine korrigierte Messwertkennlinie MWK.

## Patentansprüche

1. Verfahren zum Betrieb einer industriellen Steuerungsanlage (1) umfassend eine Automatisierungssteuerung (CPU) mit einem Ablaufprogramm (OB1), einem Ansteuermittel (2) ausgestaltet zum Ansteuern einer Schaltkomponente (SR) der Leistungselektronik und eine Eingabebaugruppe (EA), wobei durch Ein- und Ausschaltvorgänge (EV,AV) der Schaltkomponente (SR) Elektromagnetische Störungen (EMI) auftreten, welche einen über die Eingabebaugruppe (EA) aufgenommenen Messwert (MW) verfälschen,
**dadurch gekennzeichnet, dass** für die Schaltkomponente (SR) ein zeitliches Auftreten der Ein- und Ausschaltvorgänge (EV,AV) und/oder ein Betriebszustand (BZ) vorhergesagt wird, wobei die Vorhersage dazu genutzt wird eine Korrektur des Messwertes (MW) zu einem Vorhersagezeitpunkt oder während einem Vorhersage-Zeitbereich (VZB) bezüglich der Verfälschung durch die Elektromagnetische Störung (EMI) durchzuführen, wobei ein zeitliches Auftreten von Programmcode-Anweisungen (AWL) in dem Ablaufprogramm (OB1) dazu genutzt wird die Ein- und Ausschaltvorgänge (EV,AV) und/oder den Betriebszustand (BZ) vorherzusagen.

2. Verfahren nach Anspruch 1, wobei zusätzlich ein Aufzeichnungsmodul (AI) derart betrieben wird, dass während des Betriebs der industriellen Steuerungsanlage (1) ein Lernprozess für ein Neuronales-Netz (NN) in dem Aufzeichnungsmodul (AI) durchgeführt wird, dabei wird ein überwachtes Lernen durchgeführt, wobei eine im Vorhinein festgelegten zu lernende Ausgabe der Vorhersagezeitpunkte durch das zeitliche Auftreten der Programmcode-Anweisungen (AWL) in dem Ablaufprogramm (OB1) mit den tatsächlichen auftretenden Elektromagnetischen Störungen (EMI) mittels Sensordaten (SD) von Sensoren (S1,S2), welche an den Schaltkomponenten (SR) und/oder an einzuschaltenden Antrieben (M1,M2,M3) Elektromagnetische Störungen (EMI) aufzeichnen, überwacht wird, wobei aus den Sensordaten die tatsächlichen Zeitpunkte der Störungen ermittelt werden und dem Neuronalen-Netz (NN) als zusätzliche Eingangsgrößen zur Verfügung gestellt werden.

3. Verfahren nach Anspruch 1 oder **2,** wobei die Eingabebaugruppe (EA) mit einem digitalen Filter (F) betrieben wird, welcher den aufgenommenen Messwert (MW) gegen Störeinflüsse stabilisiert, dabei wird die Vorhersage dazu genutzt den Filter (F) zu parametrieren und mit dem parametrierten Filter (F) werden die Störeinflüsse minimiert.

4. Industrielle Steuerungsanlage (1) umfassend
- eine Automatisierungssteuerung (CPU) mit einem Ablaufprogramm (OB1),
- einem Ansteuermittel (2) ausgestaltet zum Ansteuern einer Schaltkomponente (SR) der Leistungselektronik und
- eine Eingabebaugruppe (EA),
wobei durch Ein- und Ausschaltvorgänge (EV,AV) der Schaltkomponente (SR) Elektromagnetische Störungen (EMI) auftreten, welche einen über die Eingabebaugruppe (EA) aufgenommenen Messwert (MW) verfälschen,
**gekennzeichnet durch**
- ein Vorhersagemittel (10), welches ausgestaltet ist für die Schaltkomponente (SR) ein zeitliches Auftreten der Ein- und Ausschaltvorgänge (EV,AV) und/oder ein Betriebszustand (BZ) vorherzusagen,
- ein Korrekturmittel (KM), welches ausgestaltet ist zu einem Vorhersagezeitpunkt (VZ) oder während eines Vorhersage-Zeitbereichs bezüglich der Verfälschung durch die Elektromagnetische Störung (EMI) den Messwert (MW) zu korrigieren, wobei das Vorhersagemittel (10) weiterhin dazu ausgestaltet ist, ein zeitliches Auftreten von Programmcode-Anweisungen (AWL) in dem Ablaufprogramm (OB1) dahingehend auszuwerten die Ein- und Ausschaltvorgänge (EV,AV) und/oder den Betriebszustand (BZ) der Schaltkomponente (SR) der Leistungselektronik vorherzusagen.

5. Industrielle Steuerungsanlage (1) nach Anspruch 4 mit einem Aufzeichnungsmodul (AI) mit einem Neuronalen-Netz (NN), welches ausgestaltet ist während des Betriebs der industriellen Steuerungsanlage(1) einen Lernprozess für das Neuronale-Netz (NN) durchzuführen, dabei ist das Aufzeichnungsmodul (AI) weiterhin dazu ausgestaltet ein überwachtes Lernen durchzuführen, bei welchen eine im Vorhinein festgelegte zu lernende Ausgabe der Vorhersagezeitpunkte durch das zeitliche Auftreten der Programmcode-Anweisungen (AWL) in dem Ablaufprogramm (OB1) mit den tatsächlichen auftretenden Elektromagnetische Störungen (EMI) mittels Sensordaten (SD) von Sensoren (S1,S2), welche an den Schaltkomponenten (SR) und/oder an einzuschaltenden Antrieben (M1,M2,M3) angeordnet sind, überwacht wird, wobei das Aufzeichnungsmodul (AI) ausgestaltet ist, die tatsächlichen Zeitpunkte der Störungen aus den Sensordaten (SD) zu ermitteln und dem Neuronalen-Netz (NN) als zusätzliche Eingangsgrößen zur Verfügung zu stellen.

6. Industrielle Steuerungsanlage (1) nach einem der Ansprüche 4 oder 5, wobei die Eingabebaugruppe (EA) mit einem digitalen Filter (F) ausgestaltet ist, welcher den aufgenommenen Messwert (MW) gegen Störeinflüsse stabilisiert, dabei ist die Eingabebaugruppe (EA) ausgestaltet mittels der Vorhersage den Filter (F) zu parametrieren und mit dem parametrierten Filter (F) die Störeinflüsse zu minimieren.

## Claims

1. Method for operating an industrial control system (1), comprising an automation controller (CPU) with a sequential program (OB1), an actuation means (2) embodied to actuate a switching component (SR) of the power electronics, and an input module (EA), wherein activation and deactivation operations (EV, AV) of the switching component (SR) give rise to electromagnetic interference (EMI) which corrupts a measured value (MW) recorded by way of the input module (EA), **characterised in that** a temporal occurrence of the activation and deactivation operations (EV, AV) and/or an operating state (BZ) is predicted for the switching component (SR), wherein the prediction is used to carry out a correction of the measured value (MW) at a prediction time instant or during a prediction time range (VZB) with respect to the corruption caused by the electromagnetic interference (EMI), wherein a temporal occurrence of program code instructions (AWL) in the sequential program (OB1) is used to predict the activation and deactivation operations (EV, AV) and/or the operating state (BZ).

2. Method according to claim 1, wherein in addition a recording module (AI) is operated in such a way that, during operation of the industrial control system (1), a learning process is carried out for a neural network (NN) in the recording module (AI), a monitored learning being carried out here, wherein a predetermined output to be learned of the prediction time instants through the temporal occurrence of the program code instructions (AWL) in the sequential program (OB1) with the actually occurring electromagnetic interference (EMI) is monitored by means of sensor data (SD) of sensors (S1, S2) which record electromagnetic interference (EMI) on the switching components (SR) and/or on drives (M1, M2, M3) to be activated, wherein from the sensor data the actual time instants of the interference are determined and made available to the neural network (NN) as additional input variables.

3. Method according to claim 1 or 2, wherein the input module (EA) is operated with a digital filter (F), which stabilises the recorded measured value (MW) against interfering influences, the prediction here being used to parameterise the filter (F) and the interfering influences being minimised with the parameterised filter (F).

4. Industrial control system (1) comprising
- an automation controller (CPU) with a sequential program (OB1),
- an actuation means (2) embodied to actuate a switching component (SR) of the power electronics, and
- an input module (EA),
wherein activation and deactivation operations (EV, AV) of the switching component (SR) give rise to electromagnetic interference (EMI) which corrupts a measured value (MW) recorded by way of the input module (EA),
**characterised by**
- a prediction means (10), which is embodied to predict a temporal occurrence of the activation and deactivation operations (EV, AV) and/or an operating state (BZ) for the switching component (SR),
- a correction means (KM), which is embodied to correct the measured value (MW) at a prediction time instant (VZ) or during a prediction time range with respect to the corruption by the electromagnetic interference (EMI), wherein the prediction means (10) is further embodied to evaluate a temporal occurrence of program code instructions (AWL) in the sequential program (OB1) in order to predict the activation and deactivation operations (EV, AV) and/or the operating state (BZ) of the switching component (SR) of the power electronics.

5. Industrial control system (1) according to claim 4, having a recording module (AI) with a neural network (NN), which is embodied to carry out a learning process for the neural network (NN) during operation of the industrial control system (1), the recording module (AI) here being further embodied to carry out a monitored learning, in which a predetermined output to be learned of the prediction time instants through the temporal occurrence of the program code instructions (AWL) in the sequential program (OB1) with the actually occurring electromagnetic interference (EMI) is monitored by means of sensor data (SD) of sensors (S1, S2) which are arranged on the switching components (SR) and/or on drives (M1, M2, M3) to be activated, wherein the recording module (AI) is embodied to determine the actual time instants of the interference from the sensor data (SD) and make them available to the neural network (NN) as additional input variables.

6. Industrial control system (1) according to one of claims 4 or 5, wherein the input module (EA) is embodied with a digital filter (F), which stabilises the recorded measured value (MW) against interfering influences, the input module (EA) here being embodied to parameterise the filter (F) by means of the prediction and to minimise the interfering influences with the parameterised filter (F).

## Revendications

1. Procédé pour faire fonctionner une installation (1) industrielle de commande comprenant une commande (CPU) d'automatisation ayant un programme (OB1) de déroulement, un moyen (2) de commande conformé pour commander un composant (SR) de coupure de l'électronique de puissance et un module (EA) d'entrée, dans lequel, par des opérations (EV, AV) de fermeture et d'ouverture du composant (SR) de coupure, se produisent des perturbations (EMI) électromagnétiques, qui faussent une valeur (MW) de mesure enregistrée par le module (EA) d'entrée, **caractérisé en ce que**
on prédit, pour le composant (SR) de coupure, une apparition dans le temps des opérations (EV, AV) de fermeture et d'ouverture, et/ou un état (BZ) de fonctionnement, dans lequel on utilise la apparition pour effectuer une correction de la valeur (MW) de mesure à un instant de prédiction ou pendant une plage (VZB) temporelle de prédiction en ce qui concerne le faussement par la perturbation (EMI) électromagnétique, dans lequel on utilise une prédiction dans le temps d'instructions (AWL) de code de programme dans le programme (OB1) de déroulement, pour prédire les opérations (EV, AV) de fermeture et d'ouverture et/ou l'état (BZ) de fonctionnement.

2. Procédé suivant la revendication 1, dans lequel on fait fonctionner en outre un module (AI) d'enregistrement, de manière à effectuer, pendant le fonctionnement de l'installation (1) industrielle de commande, une opération d'apprentissage pour un réseau (NN) neuronal dans le module (AI) d'enregistrement, en effectuant ainsi un apprentissage contrôlé, dans lequel une sortie d'apprentissage fixée à l'avance, des instants de prédiction est, par l'apparition dans le temps des instructions (AWL) de code de programme dans le programme (OB1) de déroulement, surveillée par les perturbations (EMI) électromagnétiques apparaissant réellement, au moyen de données (SD) de capteurs (S1, S2), qui enregistrent des perturbations (EMI) électromagnétiques sur le composant (SR) de coupure et/ou sur des entraînements (M1, M2, M3) à mettre en circuit, dans lequel, à partir des données de capteur, on détermine les instants réels des perturbations et on les met à disposition du réseau (NN) neuronal comme grandeurs d'entrée supplémentaires.

3. Procédé suivant la revendication 1 ou 2, dans lequel on fait fonctionner le module (EA) d'entrée avec un filtre (F) numérique, qui stabilise la valeur (MW) enregistrée à l'encontre d'influences perturbatrices, en utilisant ainsi la prédiction pour paramétrer le filtre (F) et minimiser les influences perturbatrices par le filtre (F) paramétré.

4. Installation (1) industrielle de commande comprenant
- une commande (CPU) d'automatisation ayant un programme (OB1) de déroulement,
- un moyen (2) de commande conformé pour commander un composant (SR) de coupure de l'électronique de puissance, et
- un module (EA) d'entrée,
dans laquelle, par des opérations (EV, AV) de fermeture et d'ouverture du composant (SR) de coupure, apparaissent des perturbations (EMI) électromagnétiques, qui faussent une valeur (MW) de mesure enregistrée par le module (EA) d'entrée,
**caractérisée par**
- un moyen (10) de prédiction, qui est conformé pour prédire, pour le composant (SR) de coupure, une apparition dans le temps des opérations (EV, AV) de fermeture ou d'ouverture et/ou un état (BZ) de fonctionnement,
- un moyen (KM) de correction, qui est conformé pour corriger la valeur (MW) de mesure à un instant (VZ) de prédiction ou pendant une plage temporelle de prédiction en ce qui concerne le faussement par la perturbation (EMI) électromagnétique, dans laquelle le moyen (10) de prédiction est conformé en outre pour évaluer une apparition dans le temps d'instructions (AWL) de code de programme dans le programme (OB1) de déroulement en vue de prévoir les opérations (EV, AV) de fermeture et d'ouverture et/ou l'état (BZ) de fonctionnement du composant (SR) de coupure de l'électronique de puissance.

5. Installation (1) industrielle de commande suivant la revendication 4, comprenant un module (AI) d'enregistrement, comprenant un réseau (NN) neuronal, qui est conformé pour effectuer, pendant le fonctionnement de l'installation (1) industrielle de commande, une opération d'apprentissage pour le réseau (NN) neuronal, le module (AI) d'enregistrement étant conformé en outre pour effectuer un apprentissage contrôlé, dans laquelle une sortie d'apprentissage, fixée d'avance, des points de prédiction est surveillée par l'apparition dans le temps des instructions (AWL) de code de programme dans le programme (OB1) de déroulement par les perturbations (EMI) électromagnétiques apparaissant réellement au moyen de données (SD) de capteurs (S1, S2), qui sont disposées sur le composant (SR) de coupure et/ou sur des entraînements (M1, M2, M3) à mettre en circuit, dans laquelle le module (AI) d'enregistrement est conformé pour déterminer les instants réels des perturbations à partir des données (SD) de capteurs et pour les mettre à disposition du réseau (NN) neuronal comme grandeurs d'entrée supplémentaires.

6. Installation (1) industrielle de commande suivant l'une des revendications 4 ou 5, dans laquelle le module (EA) d'entrée est équipé d'un filtre (F) numérique, qui stabilise la valeur (MW) de mesure enregistrée à l'encontre d'influences perturbatrices, le module (EA) d'entrée étant conformé pour paramétrer le filtre (F) au moyen de la prédiction et pour minimiser les influences perturbatrices par le filtre (F) paramétré.
